# EUROPEAN PATENT APPLICATION

(11) **EP 4 033 529 A1**
(43) Date of publication of application: **27.07.2022**
(21) Application number: 20864616.6
(22) Date of filing: 28.06.2020
(51) Int. Cl.: H01L 25/075, H01L 23/31

(54) **LIGHT EMITTING DIODE PACKAGING ASSEMBLY**

(30) Priority: 18.09.2019 CN 201921553483 U; 18.09.2019 CN 201921553484 U
(71) Applicant: Quanzhou Sanan Semiconductor Technology Co., Ltd., Quanzhou, Fujian 362343 (CN)
(72) Inventor: XIN, Shuning, Xiamen, Fujian 361009 (CN); HSU, Chen-ke, Xiamen, Fujian 361009 (CN); CAO, Aihua, Xiamen, Fujian 361009 (CN); SHI, Junpeng, Xiamen, Fujian 361009 (CN); WONG, Weng-Tack, Xiamen, Fujian 361009 (CN); LIAO, Yanqiu, Xiamen, Fujian 361009 (CN); LIN, Zhen-duan, Xiamen, Fujian 361009 (CN); YU, Changchin, Xiamen, Fujian 361009 (CN); LIAO, Chi-wei, Xiamen, Fujian 361009 (CN); WU, Zheng, Xiamen, Fujian 361009 (CN); LEE, Chia-en, Xiamen, Fujian 361009 (CN)
(74) Representative: Petraz, Gilberto Luigi
(86) International application number: PCT/CN2020/098503
(87) International publication number: WO 2021/051925

(57) **Abstract**

An LED package assembly comprises a plurality of LED chips spaced apart from one another, each LED chip comprising a first surface, a second surface opposite to the first surface, a side surface interconnecting the first surface and the second surface, and a set of electrodes formed on the second surface, the set of electrode comprising a first electrode and a second electrode, the first surface being a light-emitting surface; an encapsulation layer, being a light-absorbing layer, filling gaps between the LED chips and covering the side surfaces of the LED chips, exposing the first electrodes and the second electrodes of the LED chips; a wiring layer formed on the second surfaces of the LED chips and having a first surface, a second surface opposite to the first surface, and a side surface interconnecting the first surface and the second surface, the first surface being connected to the set of electrodes of the LED chip; and an insulating layer formed on and covering a surface of the encapsulation layer, the insulating layer covering the wiring layer, the insulating layer comprising a structure of one or more layers, at least one of which is a transparent layer.

## Description

Related applications: this application claims priority to Chinese Utility Model Patent Application No. 201921553483.2, entitled "LIGHT-EMITTING DIODE PACKAGE ASSEMBLY", filed Sep. 18, 2019, and Chinese Utility Model Patent Application No. 201921553484.7, entitled "LIGHT-EMITTING DIODE PACKAGE ASSEMBLY", filed Sep. 18, 2019, the entire contents of which are incorporated by reference in this application.

### TECHNICAL FIELD

The present invention relates to a package assembly, in particular to a light-emitting diode package assembly, and a light-emitting device comprising a light-emitting diode package assembly.

### BACKGROUND

Nowadays, light-emitting diode (LED) is one of the most popular light source technologies and can be used as light sources for lighting devices as well as various electronic products, for example, various display devices such as TVs, cellular phones, PCs, notebook PCs, personal digital assistants (PDAs), etc. Reducing the size of LED devices can improve the resolution of the display, thus expanding the application fields of LED displays, such as cell phones, car panels, TVs, computers, video conferencing, etc. Currently, the mainstream displays use a package size of 2121 and 1010. With the development of technology, a package size of 0808 or even smaller has emerged.

### SUMMARY

### TECHNICAL PROBLEMS

### SOLUTIONS TO THE PROBLEMS

### TECHNICAL SOLUTIONS

The object of the present invention is to provide an ultra-small pitch light-emitting diode package assembly.

In some embodiments, an LED package assembly comprises: a plurality of LED chips spaced apart from one another, each LED chip comprising a first surface, a second surface opposite to the first surface, a side surface interconnecting the first surface and the second surface, and a set of electrodes formed on the second surface, the set of electrode comprising a first electrode and a second electrode, the first surface being a light-emitting surface; an encapsulation layer, being a light-absorbing layer, filling gaps between the LED chips and covering the side surfaces of the LED chips, exposing the first electrodes and the second electrodes of the LED chips; a wiring layer formed on the second surfaces of the LED chips and having a first surface, a second surface opposite to the first surface, and a side surface interconnecting the first surface and the second surface, the first surface being connected to the set of electrodes of the LED chip; and an insulating layer formed on and covering a surface of the encapsulation layer, the insulating layer covering the wiring layer, the insulating layer comprising a structure of one or more layers, at least one of which is a transparent layer.

The encapsulation layer of the above-mentioned LED package assembly uses a colored light-absorbing layer, and the insulating layer is selected from a transparent layer, so that materials such as silicone or epoxy resin can be used directly without adding additional colorants such as toner or dyes, avoiding a decrease in reliability (e.g., a decrease in insulation performance) otherwise caused by possible defects such as unevenness and interface defects due to the addition of colorants, which can ensure the reliability of the encapsulation of the insulating layer to the wiring layer.

In some embodiments, the LED chips of each light-emitting unit are arranged in a column in a first direction, and the first and second electrodes of each LED chip are arranged side by side in a second direction.

In some embodiments, the wiring layer connects in parallel the first electrodes of the first, second and third LED chips of two or more adjacent light-emitting units in the first direction, and connects in parallel the second electrodes of the first, second and third LED chips of two or more adjacent light-emitting units in the second direction, thereby electrically connecting the plurality of light-emitting units to form an all-in-one light-emitting module.

In some embodiments, the package assembly does not have a package substrate for carrying the LED chips, and the LED chips are held in position by the encapsulation layer.

Further, the package assembly has an N-in-one light-emitting module, wherein N=m×n, and the distance D1 between adjacent light-emitting units is preferably 0.8mm or less. N may take integers above 4, such as 4, 6, 8, 9, 16, 32 or 64, etc. The larger the value of N, the smaller the value of D1 is. For example, when N is 4~9, D1 can be 0.4-0.8, and when N is 8 or more, then D can be 0.1~0.4.

In some embodiments, the package assembly also includes pads for external connections. The number of pads P is equal to n+m×a, where a is the number of LED chips for each the light-emitting unit, and n ≥ m. By such design, the number of pads of the package assembly can be reduced as much as possible so as to facilitate wiring and also facilitate chip placement at the application end, reducing the risk of short circuit.

In some embodiments, the LED package assembly comprises: a plurality of LED chips spaced apart from one another, each LED chip comprising a first surface, a second surface opposite to the first surface, a side surface interconnecting the first surface and the second surface, and a set of electrodes formed on the second surface, the set of electrode comprising a first electrode and a second electrode, the first surface being a light-emitting surface; a first encapsulation layer, filling gaps between the LED chips and covering the side surfaces of the LED chips, exposing the first electrodes, the second electrodes and at least part of the first surfaces of the LED chips, the first encapsulation layer being a colored layer; a second encapsulation layer, formed on the first encapsulation layer and covering the first surfaces of the LED chips, the second encapsulation layer being a light-transmissive layer with a predetermined transmittance greater than that of the first encapsulation layer; a wiring layer formed on the second surfaces of the LED chips and having a first surface, a second surface opposite to the first surface, and a side surface interconnecting the first surface and the second surface, the first surface being connected to the set of electrodes of the LED chip; and an insulating layer formed on and covering a surface of the encapsulation layer, the insulating layer covering the wiring layer.

In the LED package assembly, firstly, a colored material layer is used as the first encapsulation layer to fill the gaps between the multiple LED chips and cover the side walls of the LED chips, which can prevent the light interference between the LED chips. A transparent or translucent material layer is formed as the second encapsulation layer on the light-emitting surface of the multiple LED chips, which on the one hand can protect the light-emitting surface of the LED chips, and on the other hand It can be used as a light scattering layer to produce a light scattering effect. It can effectively reduce dizziness when the LED package assembly is finally used in a display panel. Further, the encapsulation layer shown can include light scattering materials, such as scattering particles.

Further, the transmittance of the second encapsulation layer can be adjusted according to different needs so as to achieve the best display effect. For example, when applied to indoor display, a translucent material can be selected as the second encapsulation layer with a transmittance preferably between 40%~80%, which further reduces dizziness. When applied to outdoor display, a transparent layer with a transmittance preferably above 70% can be selected.

In some embodiments, the second encapsulation layer is preferably below 20 µm, more preferably below 10 µm, for example, 10 µm, and with the light-emitting surfaces of the LED chips being located at substantially the same height (with a height difference of 10 µm or less), it helps to unify the light-emitting surfaces and reduce the impact of light crosstalk between sidewalls, while substantially increasing the pixel regions.

In some embodiments, the wiring layer connects in parallel the first electrodes of the first, second and third LED chips of two or more adjacent light-emitting units in the first direction, and connects in parallel the second electrodes of the first, second and third LED chips of two or more adjacent light-emitting units in the second direction, thereby electrically connecting the plurality of light-emitting units to form an all-in-one light-emitting module.

### BENEFICIAL EFFECTS OF THE INVENTION

### BENEFICIAL EFFECTS

The functions and effects of the invention includes: the invention adopts the form of packaging without a substrate, the LED chips of multiple light-emitting units are held by the encapsulation layer, and the LED chips of the multiple light-emitting units are connected in series and/or in parallel by forming a multi-layer wiring layer on the back of the multi-layer light-emitting units. The first wiring layer connects the LED chips of multiple pixel regions in series and/or in parallel, and through the via layer and the second wiring layer, rewiring is performed to form an integrated thin and small-pitch light-emitting diode package assembly. In addition, by a reasonable wiring layer design, on the one hand, it reduces the number of pads for external connection of the package assembly, thus reducing the difficulty of chip placement at the application end, while improving the reliability of the product. Furthermore, the number of layers of the wiring layer is no more than four, which ensures that the product is light and thin, conducive to the thin and light end products.

Other features and advantages of the present invention will be set forth in the subsequent specification and, in part, become apparent from the specification or are understood by carrying out the present invention. The objects and other advantages of the present invention may be achieved and obtained by means of the structures specifically indicated in the specification, the claims, and the accompanying drawings.

### BRIEF DESCRIPTION OF DRAWINGS

### DESCRIPTION OF DRAWINGS

Other features and effects of the present invention will be clearly presented in the embodiment with reference to the drawings.
FIG. 1 is a perspective view illustrating a structure of a light-emitting diode (LED) package assembly of the present invention.
FIG. 2 is a side sectional schematic view illustrating a structure of an LED package assembly according to an embodiment of the present invention.
FIG. 3 is a top-view schematic diagram illustrating an arrangement of LED chips of an LED package assembly according to an embodiment of the present invention.
FIG. 4 is a side sectional schematic view showing the LED chip of the LED package assembly of the embodiment is a conventional LED chip.
FIG. 5 is a side sectional schematic view illustrating a way of die bonding of the LED chips of the LED package assembly of the embodiment.
FIG. 6 is a side sectional schematic view showing a first wiring layer of the LED package assembly of the embodiment.
FIG. 7 is a top-view schematic diagram showing the first wiring layer of the LED package assembly of the embodiment.
FIG. 8 is a side sectional schematic view showing a via layer of the LED package assembly of the embodiment.
FIG. 9 is a top-view schematic diagram showing a via layer of the light-emitting diode package assembly of the present invention.
FIG. 10 is a side sectional schematic diagram showing a second wiring layer of the LED package assembly of the embodiment.
FIG. 11 is a top-view schematic diagram showing the second wiring layer of the LED package assembly of the embodiment.
FIG. 12 is a top-view schematic diagram showing the first wiring layer, the via layer, and the second wiring layer of the LED package assembly of the embodiment.
FIG. 13 is a circuit diagram illustrating circuit connections of the LED package assembly of the embodiment.
FIG. 14 is a top-view schematic diagram illustrating an arrangement of LED chips and a first wiring layer of an LED package assembly of an embodiment of the present invention.
FIG. 15 is a top-view schematic diagram showing a second wiring layer of the LED package assembly of the embodiment of the present invention.
FIG. 16 is a top-view schematic diagram showing the first wiring layer, a via layer, and a second wiring layer of the LED package assembly of the embodiment of the present invention.
FIG. 17 is a circuit diagram illustrating circuit connections of the LED package assembly of the embodiment.
FIG. 18 is a schematic diagram of circuit connection illustrating wiring connections of an LED package assembly of a further embodiment of the present invention.
FIG. 19 is a schematic diagram of circuit connection illustrating wiring connections of an LED package assembly of a further embodiment of the present invention.
FIG. 20 is a top-view schematic diagram illustrating a first wiring layer of an LED package assembly of a further embodiment of the present invention.
FIG. 21 is a top-view schematic diagram illustrating a second wiring layer of the LED package assembly of the embodiment of the present invention.
FIG. 22 is a top-view schematic diagram illustrating a third wiring layer of the LED package assembly of the embodiment of the present invention.
FIG. 23 is a side sectional schematic diagram illustrating a structure of an LED package assembly of an embodiment of the present invention.

### EMBODIMENTS OF THE INVENTION

### IMPLEMENTATION OF THE INVENION

Before the present invention is described in detail, it should be noted that in the following description, similar components are denoted by the same number.

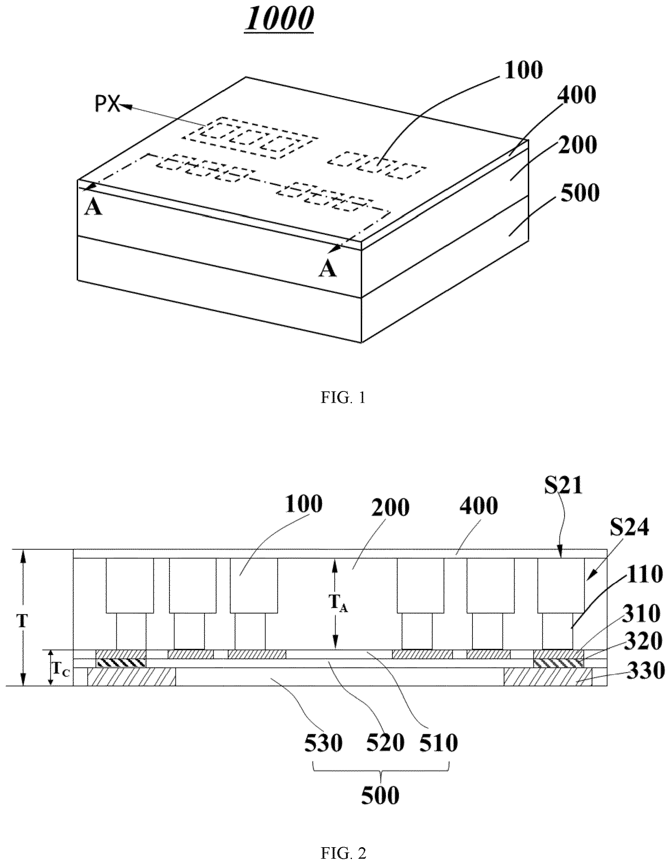

Referring to FIGS. 1 and 2, a light-emitting diode (LED) package assembly according to an embodiment of the present invention is provided, which is an LED package assembly without a substrate. The LED package assembly may comprise a plurality of light-emitting units arranged in an m×n matrix, where m and n are integers greater than 1. Each light-emitting unit includes a plurality of LED chips of different wavelengths, preferably, for example, at least three LED chips emitting red light (R), green light (G), and blue light (B), respectively. It may also include an LED chip emitting white light (including a wavelength conversion layer), that is, a combination of RGBW is formed so that the brightness of a display can be enhanced, which is very beneficial for outdoor display. Each light-emitting unit is equivalent to a pixel region PX, which can also be referred to as a pixel. In a specific embodiment, the LED package assembly includes 2×2 pixel regions. Each pixel region PX includes a plurality of LED chips 100 spaced apart from one another and having an emitting surface S21. The package assembly also includes an encapsulation layer 200 that holds the plurality of LED chips 100 and fills gaps between the plurality of LED chips 100, and a multi-layer wiring layer located on the encapsulation layer. The multi-layer wiring layer includes a first wiring layer 310, a via layer 320 and a second wiring layer 330. Electrical isolation is provided between these layers by an insulating layer 500. The first wiring layer 310 is formed on the lower surfaces of the plurality of LED chips, connecting the plurality of LED chips in parallel and/or in series. The via layer 320 is formed on and electrically connected to the first wiring layer 310. The second wiring layer 330 is formed on and electrically connected to the via layer 320.

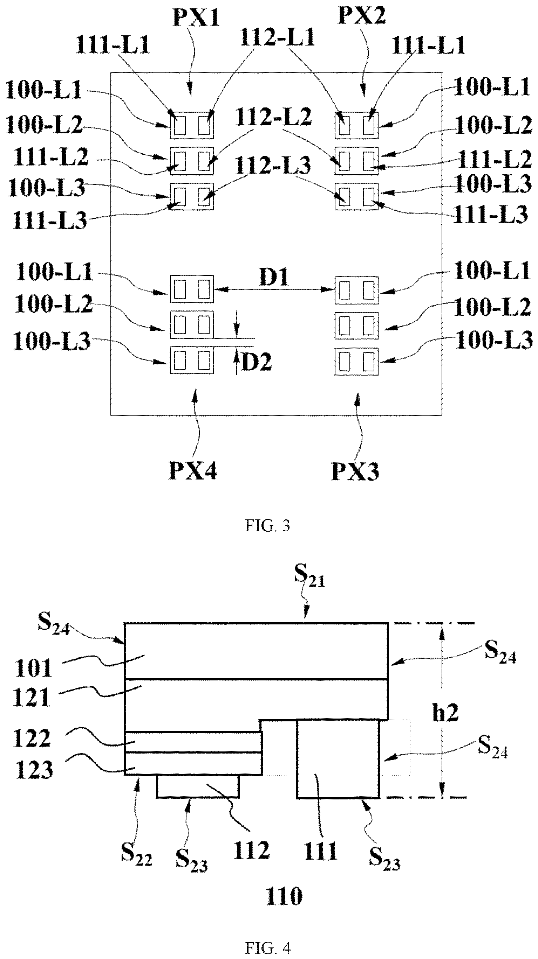

FIG. 3 briefly illustrates the arrangement of the LED chips of the package assembly. Referring to FIG. 3, the package assembly includes four pixel regions PX1 to PX4, each pixel region PX including a plurality of LED chips 100, such as a first LED chip 100L1, a second LED chip 100L2, and a third LED chip 100L3. In other embodiments, each pixel region may also include only two LED chips or more than three LED chips, for example, four LED chips. The three LED chips 100L1, 100L2, and 100L3 may emit light of different wavelengths, for example, they may emit red light, green light, and blue light, respectively.

Referring to FIG. 4 which shows one of the above LED chips 100L1 to 100L3, each of the above LED chips 100L1 to 100L3 has a pair of electrodes 110 on the same side, a first surface S21, a second surface S22 opposite to the first surface, a side surface S24 interconnecting the first surface S21 and the second surface S22, and an electrode surface S23. The first surface S21 is a light-emitting surface S21, and the second surface S22 is provided with the pair of electrodes 110. Further, the LED chip includes a substrate 101, a first type semiconductor layer 121, a light-emitting layer 122 and a second type semiconductor layer 123. The first type semiconductor layer 121 and the second type semiconductor layer 123 may be p-type and n-type semiconductor layers, respectively. The LED chip also includes a transparent substrate 101 located on the first type semiconductor layer 121. The LED chip electrode set 110 includes a first electrode 111 electrically connected to the first type semiconductor layer 121, and a second electrode 112 electrically connected to the second type semiconductor layer 123. In some other embodiments, each LED chip electrode set 110 also includes a thickened layer of conductive material. The thickened layer is provided between the first electrode 111 and the first wiring layer, and between the second electrode 112 and the first wiring layer 310, respectively, and can be formed by electroplating, chemical plating or printing, etc. The material can be Cu, CuₓW or other conductive metal materials. By increasing the thickness of the electrodes, the contact area between the side surface S24 of the LED chip and the encapsulation layer 200 can be increased, and thus the adhesion between the LED chip and the encapsulation layer 200 can be improved. Preferably, the thickness of the electrode set of each LED chip is 5~200 µm, for example, it may be 5 -30 µm, 30~50 µm, or 80~120 µm, depending on the specific needs. The LED chip 100 may be an LED chip with a conventional size (a side of the chip is generally more than 200µm), or Mini LED chip (the chip size is generally between 100~200µm), or Micro LED chip (the chip size is generally no more than 100µm). Mini LED chip or micro LED chip are preferable in the embodiment.

Referring to FIG. 3, the first, second and third chips LED-100L1 ~100-L3 in each pixel region PX of the package assembly are arranged in a straight line, and specifically, individual LED chips of each light-emitting unit are arranged in a column in a first direction, and the first and second electrodes of each LED chip are arranged side by side in a second direction, where the first direction and the second directions are substantially perpendicular. In this embodiment, the first electrode 111 and the second electrode 112 are in a left-right arrangement, the polarities of the electrodes of two adjacent columns of LED chips are opposite. In other words, the electrodes of the adjacent columns of chips are symmetrical, which can facilitate wiring and thereby reducing the distance between the chips. Taking the package assembly shown in FIG. 3 as an example, the polarities of the electrodes of the three LED chips 100L1~100L3 in the first pixel region PX1 are opposite to the polarities of the electrodes of the three LED chips 100L1~L3 in the second pixel region PX2. If considering each pixel region as a pixel, the distance D1 for each pixel is preferably 1 mm, more preferably, 0.8 mm or less, for example, 0.1~0.3 mm, 0.3-0.5 mm, or 0.5~0.8 mm. The distance D2 between the chips in the same pixel region PX is preferably 100 µm or less, for example, 50~100 µm, or 50 µm or less. In some display applications, the distance between LED chips in the same pixel region is preferably 50 µm or less, for example, 40~50 µm, 30~40 µm, 20~30 µm, or 10~20 µm. The smaller the distance, the better it is to reduce the size of this LED package assembly and thus improve the resolution of the display.

Referring again to FIG. 2, a first encapsulation layer 200 is filled around the plurality of first, second, and third LED chips 100L1-100L3. Preferably, the encapsulation layer 200 has a light transmittance of less than 30%. More preferably, the encapsulation layer 200 has a light transmittance of 5%-20%. Optionally, the encapsulation layer 200 is opaque and nontransparent. Specifically, it includes light-absorbing component (not shown in the figures). The light-absorbing component is provided at least around the side walls of the LED chips or between adjacent LED chips, or further at least around the LED semiconductor light-emitting stacked layers or between adjacent semiconductor light-emitting stacked layers. The light-absorbing component may specifically be light-absorbing particles dispersed within the epoxy resin or silicone used in the encapsulation layer, such as black particles, or toner. Alternatively, the light-absorbing component may be a black resin. The light-absorbing component of the encapsulation layer 200 is provided at least around the LED sidewalls to prevent light-emitting form the side of the LED chips, thereby the emitted light of the LED chip is mainly from or all from the light-emitting surfaces of the LED chips, reducing crosstalk or mixing of light from different LED chips in the side direction. In a specific embodiment, the encapsulation layer 200 may be epoxy resin or silicone with black colorant, so that all areas of the entire LED package assembly are black, except the light-emitting surface S21 of the LED chips 100, which helps to improve the contrast of display panel. At the same time, each LED chip 100 is isolated through the black encapsulation material to reduce the light interference between individual LED chips. In some embodiments, the hardness of the encapsulation layer 200 is preferably D60 or above, more preferably, D85 or more.

Further, a transparent or translucent material layer is formed on the encapsulation layer 200 as another encapsulation layer 400, which covers the first surface S21 of the plurality of first, second, and third LED chips, preventing the LED chips from being exposed. The encapsulation layer 400 can be used as a light scattering lens to produce a light scattering effect. When the final LED package assembly is used in the display panel, it can effectively reduce the dizziness. Further, the illustrated encapsulation layer 400 may include a light scattering material, such as scattering particles. The thickness of the encapsulation layer 400 is preferably between 5 ~ 20µm, such as 10µm, which, on the one hand, can protect the light-emitting surface of the LED chips, and on the other hand, with the encapsulation layer 200 using a light-absorbing material, can reduce the light interference between individual LED chips. The light transmittance is preferably 40% or more. In some embodiments, the LED package assembly is used for indoor display, in which, the encapsulation layer 400 is preferably a translucent layer with a light transmittance of preferably 40%~80%, more preferably 70~80%, which can reduce the brightness of the LED chip and thereby reduce light dizziness. In some embodiments, the package assembly is used in the outdoor display, in which, the encapsulation layer 400 is preferably a transparent layer with a light transmittance of preferably 80% or more, more preferably 80%.

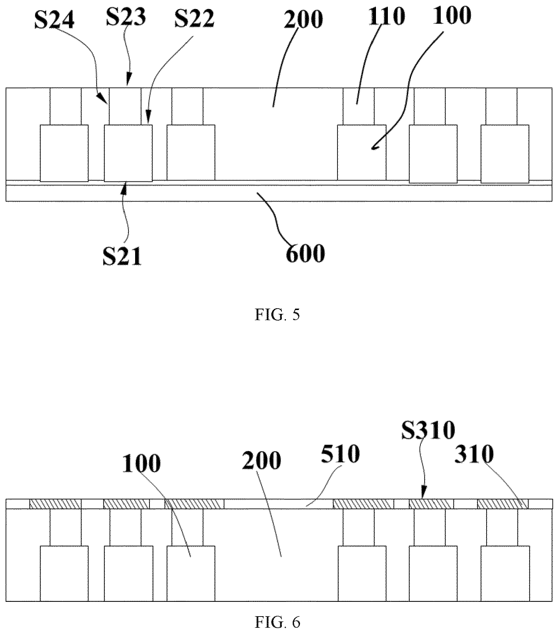

In this embodiment, the plurality of first, second, and third LED chips 100L1~L3 may first be temporarily adhered to a support 600 such as a tape by taking the light-emitting surface S21 of the LED chips 100 as a die-bonding surface, when the electrode surface S24 is facing upward, and then a fluid insulating material is filled between the chips and solidified as the encapsulation layer 200, exposing the electrode surface S23 of the LED chips. As shown in FIG. 5, in this embodiment, the thickness of the adhesive material 610 of the tape 600 is preferably controlled to be 5~20µm, which on the one hand ensures that the LED chips will not be displaced when filling the encapsulation layer, and on the other hand ensures that the first surface S21 of the first, second and third LED chips 100L1~L3 are substantially located at the same level with a height difference substantially below 10µm, which facilitates unifying the light-emitting surfaces and reduces light crosstalk between sidewalls, while significantly increasing the pixel regions of the package assembly.

The multi-layer wiring layer is formed on the second surface of the plurality of LED chips and specifically includes a first wiring layer 310, a via layer 320, and a second wiring layer 330. The first wiring layer 310 is connected to the electrodes 110 of the LED chips, the via layer 320 is formed on the first wiring layer 310, and the second wiring layer 330 is formed on the via layer 320 and is electrically connected to the first wiring layer 310 through the via layer 320. The multi-layer wiring layer is preferably made of a metal material with a melting point higher than 400°C, such as Ag, Cu, Ni, Al, etc. The material of these layers may be the same or different, and may be formed by electroplating, chemical plating or printing, etc. The thickness of each layer is preferably 100 µm or less.

Referring to FIG. 6, the first wiring layer 310 is formed on the surface of the encapsulation layer 200 and are electrically connected to the electrodes 110 of the plurality of LED chips. An insulating layer 510 is filled in the gaps between the wires of the first wiring layer 310, exposing a surface S310 of the first wiring layer 310 away from the LED chips. The material of the insulating layer 510 may be the same as the material of the encapsulation layer 200, or different. When the same material is used, the insulating layer 510 and the encapsulation layer 200 form a single layer, and it is difficult to distinguish the two. In an embodiment, for example, the LED package assembly is used in a display device, and the insulating layer 510 and the encapsulation layer 200 are both epoxy resin or silicone with colorant. In some embodiments, the hardness of the insulating layer 510 is not less than the hardness of the first wiring layer 310, for example, D60 or above, more preferably, D85 or above, which helps to expose the surface S310 of the first wiring layer 310 by grinding.

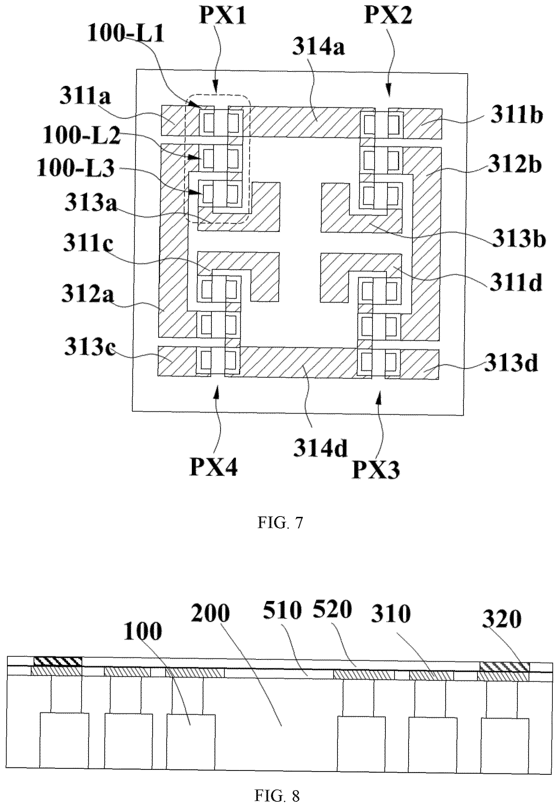

The first wiring layer 310 includes a plurality of first wires and at least two common wires, thereby electrically connecting the LED chips of the multiple pixel regions PX to form an n-in-one pixel region. FIG. 7 illustrates an example of a four-in-one package assembly, in which the LED chips of four pixel regions are connected in series and/or parallel. In other embodiments, it is not limited to a four-in-one structure, but may also be a nine-in-one or sixteen-in-one, etc. In the package assembly shown in FIG. 7, this first wiring layer 310 includes two common wires 314a, 314d and ten first wires, where the first wires 311a~311d are connected to the first electrodes 111 of the first chips 100-L1 of the pixel regions PX, respectively. The wires 313a~313d are connected to the first electrodes 111 of the third chips 100-L3 of the PX. The wire 312a is connected to the first electrodes of the second LED chips 100-L2 of PX1 and PX4. The wire 312b is connected to the first electrodes of the second LED chips 100-L2 of PX2 and PX3. The common wire 314a is connected to the second electrodes 112 of the first, second, and third LED chips of PX1 and PX2, and the common wire 314d is connected to the second electrodes 112 of the first, second, and third LED chips of PX3 and PX4.

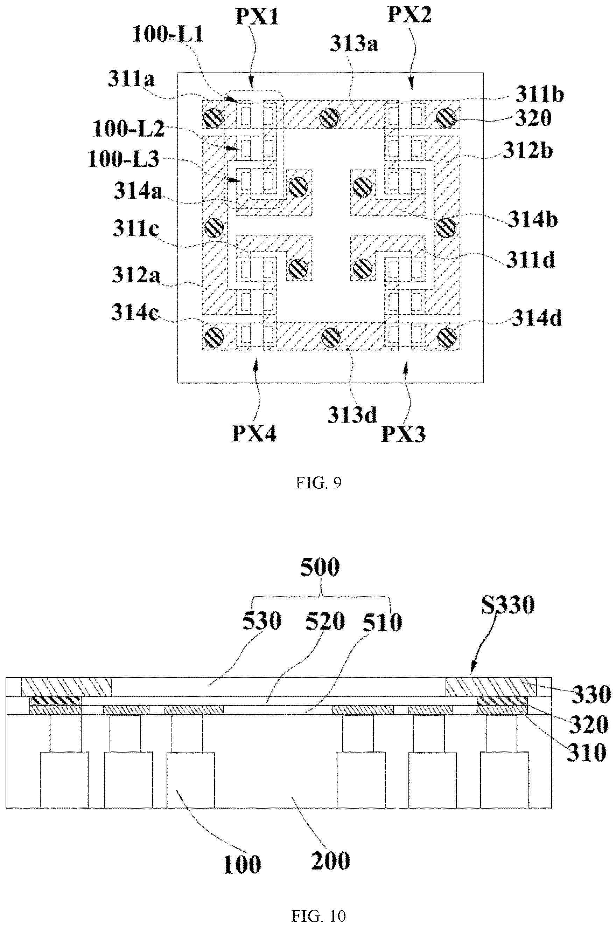

Referring to FIGS. 8 and 9, the via layer 320 is located on the surface S310 of the first wiring layer 310, including a plurality of vias 320 formed in an insulating layer 520. The number and location of the vias correspond to the individual wires of the first wiring layer. The pattern filled with solid diagonal lines in FIG. 9 represents the vias, which are as far away from each LED chip as possible. The material of the insulating layer 520 may be referred to the insulating layer 510. The thickness of the via layer is usually less than 100µm. In some embodiments that the package assembly has a thinner structure, the thickness of the via layer is preferably 20~50µm, for example, 25~30µm, so as to avoid excessive stress and thermal resistance due to the large thickness of the via layer, and reduce the total thickness of the package structure, while ensuring the strength of the package structure, making the end products thinner and lighter. In other embodiments, the via layer has a thickness of 50~80 µm, for example 60 µm, thus appropriately increasing the thickness of the package assembly and thus facilitating pickup of a device from the sidewalls thereof.

Referring to FIG. 10, the second wiring layer 330 is located on the via layer 320 and forms an electrical connection with the first wiring layer 310 through the respective vias of the via layer 320. An insulating layer 530 is filled in the gaps between the wires of the third wiring layer 330, exposing a surface S330 of the second wiring layer 330 away from the LED chips. The material of the insulating layer 530 may be referred to the insulating layer 510.

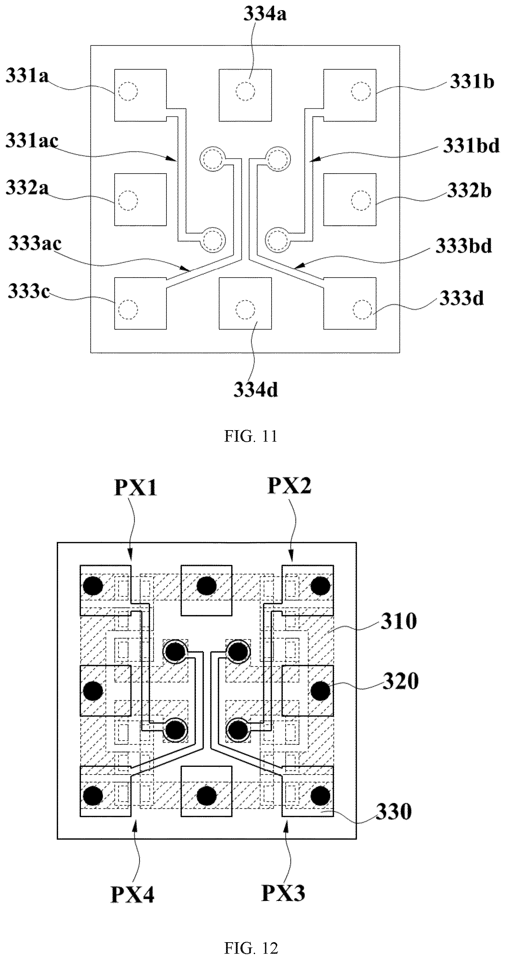

Referring to FIG. 11, the wires of the third wiring layer 330 includes a plurality of connecting wires 331ac, 331bd, 333ac, 333bd and a plurality of connecting portions 331a, 331b, 332a, 332b, 333c, 333d, 334a and 334d, where the connecting wires are used to connect the electrodes of the same type of LED chips and which have the same polarity. For example, the connection 331ac connects the first electrodes 111 of the first LED chips 100-L1 of PX1 and PX3, and the connection 333ac connects the first electrodes 111 of the third LED chips 100-L3 of PX1 and PX3. The connecting portions can be used as electrode pads for external connection, for being connected to a power supply. In a preferred embodiment, a pad can be made in the corresponding area of the connecting portion and the area outside the pad can be covered with ink, epoxy resin or other insulating material to protect the wires of the second wiring layer 330. In a preferable embodiment, the connecting portions of the second wiring layer 330 completely covers each via of the via layer 320, increasing the contact area between the second wiring layer and the vias. In addition, in terms of process, conductive material of the via layer and the second wiring layer can be formed in the same process, saving a process of forming conductive material and grinding, which can effectively save costs and improve product stability.

The insulating layers 510~530 may be of the same material or of different materials, specifically selected from epoxy resin, silicone, polyimide, benzocyclobutene, or PBO. When composed of the same material, the insulating layers 510~530 are combined into a single layer 500, which is difficult to distinguish them. In some specific embodiments, the insulating layers 510-530 are made of opaque or low-transmittance materials, such as epoxy resin or silicone doped with a black colorant, preventing or reducing the light emitted from the LED chips from a rewiring layer which may otherwise cause crosstalk. When an opaque or low-transmittance material is used as the insulating layer, a metal wire pattern in the wiring layer can be formed first, then the insulating layer can be formed by filling, and finally the surface of the metal wires in the wiring layer can be exposed by grinding. In other embodiments, when the encapsulation layer 200 is made of a low-transmittance material or an opaque material, the insulating layers 510~530 may be partially or fully light transmissive, and the transmittance is thus higher than the that of the encapsulation layer 200. The light-transmissive layer can be made without adding colorants or light-absorbing materials, such as toner or dyes, and is preferably a silicone or epoxy resin material layer that does not contain micron-sized particles (usually particles with a diameter of 1 micron or more, such as C-powder particles), so as to avoid a decrease in reliability (e.g., a decrease in insulation performance) otherwise caused by possible defects such as unevenness and interface defects due to the addition of colorants, which can ensure the reliability of the encapsulation of the insulating layer to the wiring layer. In other embodiments, a photosensitive material is solidified to form the insulating layer, which simplifies the process. Meanwhile, the area around the chip and the non-metallic part of the electrode surface are covered with light-absorbing material as the encapsulation layer 200 to prevent crosstalk of light from the sides of the chips.

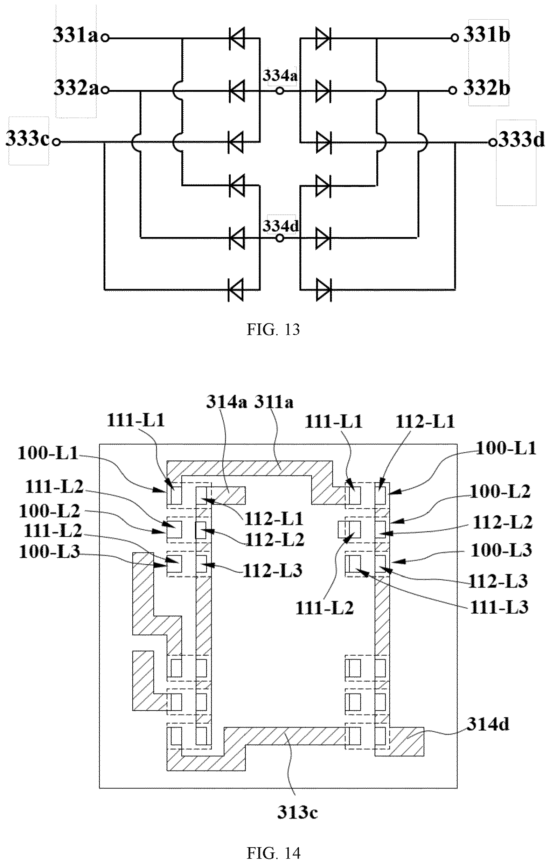

Referring to FIGS. 12 and 13, FIG. 12 shows the connection relationship of the three wiring layers, and FIG. 13 shows the equivalent circuit diagram of the four-in-one light-emitting unit. The four-in-one light-emitting unit is lead out by eight connecting portions 331a, 331b, 332a, 332b, 333c, 333d, 334a and 334d, where the first electrodes of the first LED chip 100-L1 are led out by the connecting portions 331a and 331b, the first electrodes of the second LED chips 100-L2 are led out by the connecting portions 332a and 332b, and the first electrodes of the third LED chips 100-L3 are led out by the connecting portions 333c and 333d. As common electrodes, the connecting portions 334a and 334d connect the second electrodes 112 of all LED chips of PX1 to PX4, respectively.

In this embodiment, first, in the arrangement of the LED chips, the LED chips in each PX are arranged in a straight line. Specifically, respective LED chips of each light-emitting unit are arranged in a column in a first direction. The first and second electrodes of each LED chip are arranged side by side in a second direction. The first and second directions are substantially perpendicular to each other. The polarities of the electrodes of two adjacent columns of LED chips are opposite. In the first wiring layer 310, the common electrodes of the LED chips of two adjacent PX in left-right arrangement are connected into a common electrode, and the second LED chips 100-L2 (located in the middle of the three chips) of the two adjacent PX in the up-to-down direction are connected in parallel (i.e., the first electrodes of the second LED chips of PX1 and PX3 are connected in parallel and the first electrodes of the second LED chips of PX1 and PX4 are connected in parallel). The first LED chips 100-L1 and the third LED chips 100-L3 of PX1~PX4 are individually wired to reduce the number of electrode terminals of the four-in-one light-emitting unit to 10. In the second wiring layer, the first LED chips and the second LED chips of the two adjacent PX in the up-to-down direction are then connected in parallel by wires, respectively (i.e., the first electrodes of the first LED chips of PX1 and PX3 are connected in parallel to form an electrode terminal 331a, the first electrodes of the first LED chips of PX2 and PX4 are connected in parallel to form an electrode terminal 331b, the first electrodes of the third LED chips of PX1 and PX3 are connected in parallel to form an electrode terminal 334c , and the first electrodes of the third LED chip of PX2 and PX4 are connected in parallel to form an electrode terminal 334d ). A total of 8 electrode terminals (i.e., 8 connecting portions) are led out, which effectively reduces the number of electrode pads of the package assembly and thus facilitates placement of chips.

The package assembly according to the above exemplary embodiment does not have a package substrate or holder for carrying the LED chips, the light-emitting units in the m×n matrix arrangement are mainly held and supported by insulating material layers (including 200, 400 and 500) and wiring layers. The thickness T of the package assembly depends mainly on the thickness TA of the LED chips and the thickness TC of the wiring layer. In some specific embodiments, mini-type LED chips are used which have a thickness TA between 40 ~ 150µm. The thickness TC of the multi-layer wiring layer is between 20 ~ 200µm, more preferably between 50 ~ 150µm. T and TA meets the relationship: 1.4≤T/TA≤10. In this way, the circuit layer can avoid too much stress and too much thermal resistance, and make the total thickness of the package assembly smaller while ensuring the strength of the package structure. For example, in an embodiment, the thickness of the LED chip TA is approximately 80 µm, the thickness of the package assembly can be 120 µm-500 µm, for example, 120-200 µm, and in this case, the thickness of each sub-layer of the wiring layer can be 20-50 µm, ratio 30 µm. In another embodiment, for example, the small size of the package assembly (e.g., 0.4mm × 0.4mm or smaller) does not facilitate gripping from an upper surface of the package assembly. At this time, the thickness T of the package assembly can be increased appropriately so that the side wall of the package assembly has a larger area for a pickup device to contact and grasp, and preferably, the thickness of the package assembly can be 320-500µm, such as 340~360 µm. The thickness of the package assembly can be increased by increasing the thickness of the LED chip and/or the thickness of the wiring layer. For example, the thickness of the electrodes of the LED chip may be increased and/or the thickness of each wiring layer may be appropriately increased, where the thickness of the via layer is preferably 30~80 µm, and the thickness of the other wiring layers is preferably 50 to 100 µm. In some specific embodiments, a micro-type LED chip is used, the thickness of the chip TA is between 5 and 10 µm, and the thickness of the multi-layer wiring layer TC is between 20 µm and 200 µm. More preferably, the thickness of the wiring layer TC is between 50 µm and 150 µm. T and TA satisfy the relation: 10≤T/TA≤60, for example, the thickness of the package assembly can be 50~100 µm, or 100~200 µm.

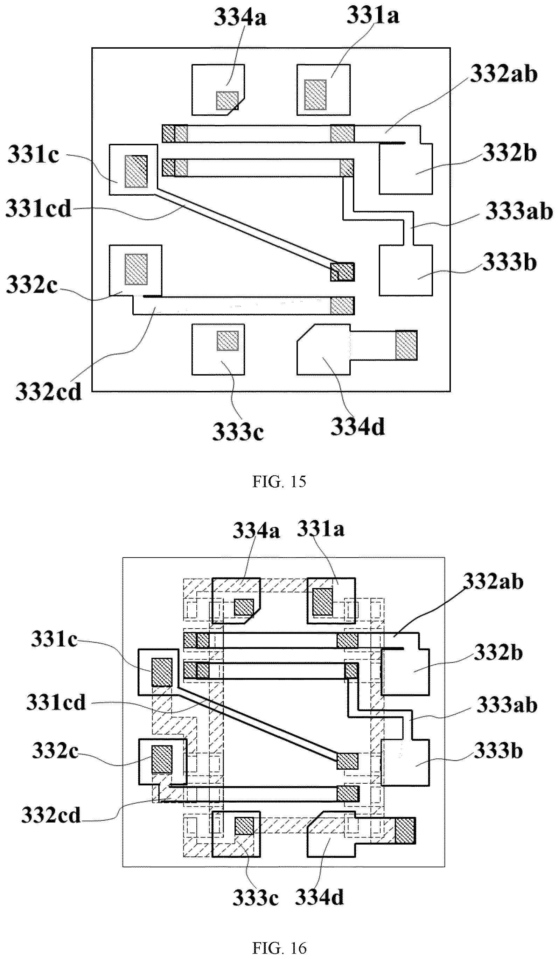

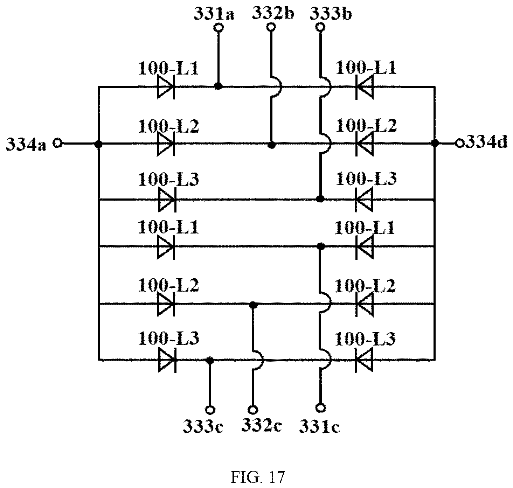

FIGS. 14~17 show another embodiment of the LED package assembly of the present invention. Referring to FIG. 14, the package assembly also includes a plurality of pixel regions PX1~PX4 arranged in an m×n matrix. Unlike the package assembly shown in Figure 3, the LED chips in the pixel regions have the same polarity direction, which is conducive to improving the efficiency and accuracy of chip alignment. In this embodiment, the first wiring layer includes first wires 311a, 313c and common wires 314a, 314d. 311a connects the first LED chip 100-L1 of the two horizontally adjacent pixel regions PX1 and PX2, 313c connects the third LED chip 100-L3 of the two horizontally adjacent pixel regions PX3 and PX4, 314a connects all LED chips of the longitudinally adjacent pixel regions PX1 and PX4, and 314d connects all LED chips of the longitudinally adjacent pixel regions PX2 and PX3. Referring to FIGS. 15 and 16, the second wiring layer includes connecting portions 331a, 331c, 332b, 332c, 333b, 333c, 334a, 334d and connecting wires 331cd, 332ab, 332cd, 333ab. 331cd connects the first LED chips 100-L1 of the horizontally adjacent pixel regions PX3 and PX4, 332ab connects the second LED chips 100-L2 of the horizontally adjacent pixel regions PX1 and PX2, 332ab connects the second LED chip 100-L2 of the horizontally adjacent pixel regions PX1 and PX2, and 333cd connects the third LED chip 100-L3 of the horizontally adjacent pixel regions PX3 and PX4. FIG. 17 shows an equivalent circuit diagram of the four-in-one package assembly, where 334a and 334d connect all LED chips of the light-emitting units located in the same column along the longitudinal direction, respectively, and 331a, 331c, 332b, 333b, 333c connect the same type of LED chips of light-emitting units located in the same row, respectively.

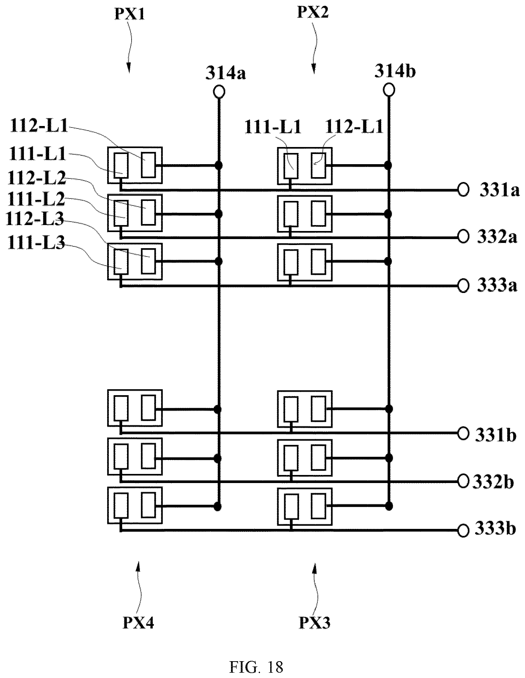

FIG. 18 shows a further embodiment of the LED package assembly of the present invention. The LED device also includes four pixel regions PX1~PX4 arranged in a 2×2 matrix, with each pixel region corresponding to a light-emitting unit. The LED chips of the pixel regions are arranged with the same polarity direction. Unlike the LED package assembly shown in FIGS. 14~17, the first wiring layer 330 includes conductive wires 314a and 314b, which connect the second electrodes 112 of all LED chips located in the same column, respectively. The second wiring layer includes conductive wires 331a~333a and 331b~333b, which connect the first electrodes 111 of the same type of LED chips located in the same row, respectively. For example, the wire 331a connects the first electrodes 111-L1 of the first type of LED chips in the first row, the wire 332a connects the first electrodes 111-L2 of the second type of LED chips in the first row, and the wire 331b connects the first electrodes 111-L1 of the first type of LED chips in the second row. The first wiring layer and the second wiring layer are separated from each other by an insulating layer, and are electrically connected to each other by via layer. The connections of wires of the first wiring layer and the second wiring layer can be switched.

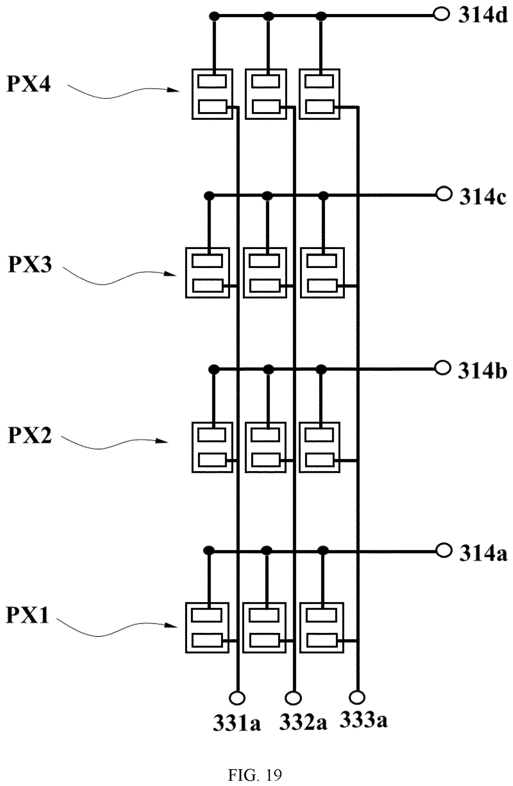

FIG.19 shows a further embodiment of the LED package assembly of the present invention. The LED device also includes four pixel regions PX1~PX4, arranged in a 4×1 matrix. Firstly, the LED package assembly is rectangular or approximately rectangular in shape, which facilitates assembly when applied to display devices and allows for a minimum number of pads for external connection through a wiring design. Specifically, the first wiring layer includes wires 314a~314d which connect in parallel the second electrodes of the light-emitting units of pixel regions PX1~PX4 in the longitudinal direction, respectively and form four electrode terminals for external connection. The second wiring layer includes wires 331a~333a which connect the same type of first, second, or third LED chips of pixel regions PX1~PX4, and form three electrode terminals for external connection. In this way, the pixel regions PX1~PX4 can form a four-in-one light-emitting module.

In this embodiment, the four-in-one LED package assembly change the arrangement of light-emitting units and uses 4 × 1 arrangement, in which the number of pads P for external connection is equal to 4+a, where a is the number of chips in a single light-emitting unit. In a specific embodiment, each light-emitting unit includes three chips, i.e. a red LED chip 100-L1, a green LED chip 100-L2 and a blue LED chip 100-L3, so only 7 pads are needed, achieving the minimum number of pads, which reduces the size of the package assembly, while conducive to wiring, chip placement at the application end, and reducing the risk of short circuit.

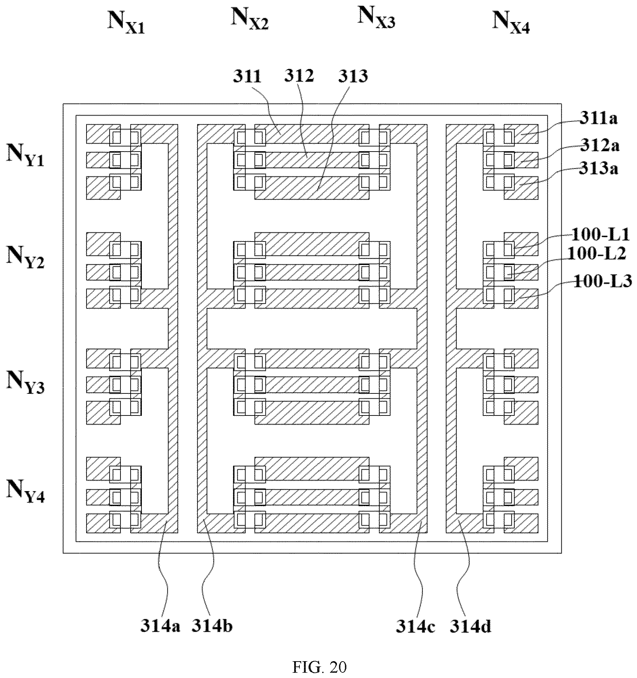

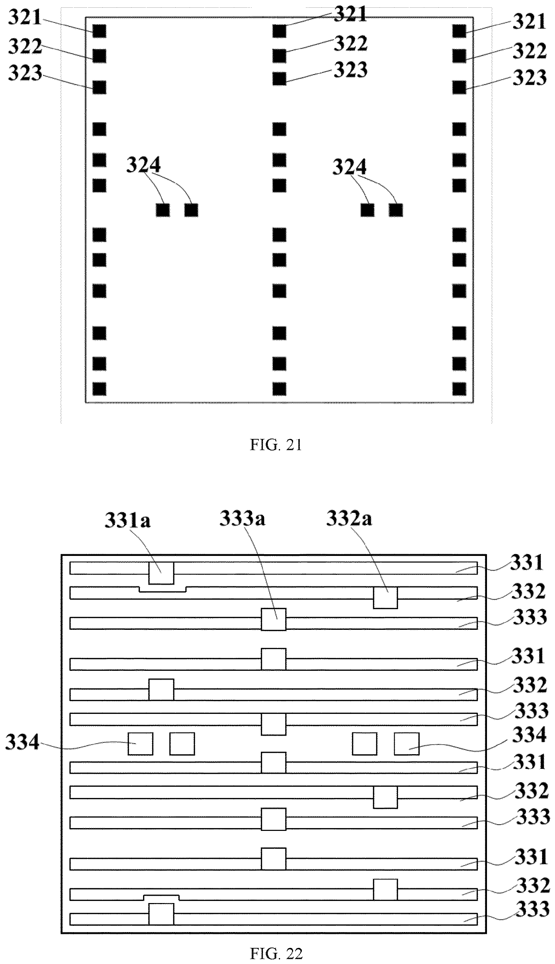

FIGS. 20 to 22 show a further embodiment of the LED package assembly of the present invention. FIG. 20 shows the arrangement of the LED chips and the first wiring layer of this LED package assembly. The LED device also includes 16 pixel regions PX1~PX4 arranged in a 4×4 matrix. The distance D1 between the individual light-emitting units of the 16-in-1 LED package assembly is preferably 0.1~0.5 mm, for example, 0.2~0.5 mm. The LED chips of each light-emitting unit is first arranged in a column in a first direction, and the first and second electrodes of each LED chip are arranged side by side in a second direction, where the first and second directions are substantially perpendicular to each other. In the first direction, the second electrodes of all the LED chips located in the same column are connected in parallel, and in the second direction, the first electrodes of the same type of LED chips located in the same row are connected in parallel. In addition, the first and second electrodes of LED chips in adjacent columns are in opposite positions, which facilitates the parallel connection of the first electrodes of the same LED chips located in the same row, thus simplifying the wiring of the wiring layer. Specifically, the first wiring layer includes common wires 314a~314d, which are connected to the second electrodes of the LED chips of the columns N_{X1}~N_{X4} of light emitting units, respectively. The first wires include 311~313, where 311 connects the first electrodes of the first LED chips L1 located in the same row of columns N_{X2} and N_{X3}, 312 connects the first electrodes of the second LED chip L2 located in the same row of columns N_{X2} and N_{X3}, and 313 connects the first electrode of the third LED chip L3 located in the same row of columns N_{X2} and N_{X3}. The first wiring also includes wires 311a~313a, which are connected to the first electrodes of the first, second and third LED chips in rows Nxi and N_{X4}, respectively. FIG. 21 shows a pattern of the via layer with a plurality of vias, out of which vias 324 are connected to the common wires 314a~314d of the first wiring layer and vias 321-323 are connected to the first wiring of the first wiring layer, respectively. FIG. 22 shows a pattern of the second wiring layer including connecting wires 331~333 and connecting portions 331a~333, 334. The connecting wire 331 connects in parallel the first electrodes of the first LED chips located in the same row, the connecting wire 332 connects in parallel the first electrodes of the second LED chips located in the same row (e.g., rows N_{Y1}~ N_{Y4}), and the connecting wire 333 connects in parallel the third LED chips located in the same row. The connecting portions serve as terminals for external connection. 331a~333a are connected to the connecting wires 331~333 respectively, and334 are connected to 324. In a preferred embodiment, pads can be made in the corresponding area of the connecting portion, and the area outside the pads is covered with ink, epoxy resin or other insulating material to protect the wires of the second wiring layer.

In the embodiment, through the reasonable arrangement of LED chips and wiring layer design, it simplifies the wires of the wiring layer, while improving the reliability of the product. Furthermore, the number of layers of the wiring layer is no more than four (including the pad layer for external connection), which ensures the product is thin and light and conducive to the thin and light end products.

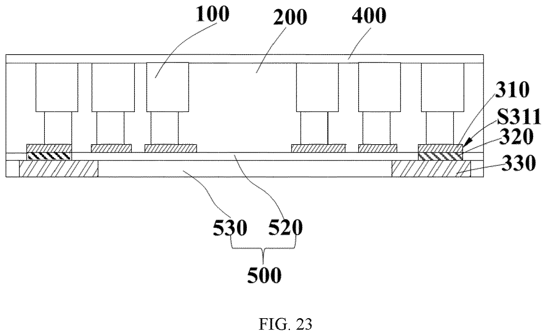

FIG. 23 shows an LED package assembly without a substrate. Unlike the package assembly shown in FIG. 2, the encapsulation layer 200 covers both the side walls of the LED chips and the side wall S311 of the first wiring layer 310. The encapsulation layer 200 is preferably opaque, or has a low light low transmittance, for example, less than 30%, such as 5~20%. Preferably, the encapsulation layer is selected from black materials, such as epoxy resin or silicone with a black colorant. The insulating layers 520 and 530 can be made of light-transmissive or opaque materials.

In summary, the LED package assembly according to the present invention uses the encapsulation layer to hold and encapsulate the pixel dots arranged in a matrix, and provides a multi-layer wiring layer to connect the LED chips of the pixels in series. Therefore, the present invention does not require solder wires and circuit board with precise wiring, improving reliability and contrast. In addition, the electrode set of the LED chip does not need to be soldered with solder paste onto the board, avoiding poor chip soldering and improving the integration of LED and electronic components, so it indeed achieves the purpose of this invention.

However, the above mentioned are only embodiments of the present invention, and cannot be used to limit the scope of the of the present invention. All the simple equivalent changes and modifications made in accordance with the scope of the patent application and the patent specification of the present invention are still within the scope of the coverage of the present invention.

## Claims

1. A light-emitting diode package assembly, comprising:
a plurality of LED chips spaced apart from one another, each LED chip comprising a first surface, a second surface opposite to the first surface, a side surface interconnecting the first surface and the second surface, and a set of electrodes formed on the second surface, the set of electrode comprising a first electrode and a second electrode, the first surface being a light-emitting surface;
an encapsulation layer, being a light-absorbing layer, filling gaps between the LED chips and covering the side surfaces of the LED chips, exposing the first electrodes and the second electrodes of the LED chips;
a wiring layer formed on the second surfaces of the LED chips and having a first surface, a second surface opposite to the first surface, and a side surface interconnecting the first surface and the second surface, the first surface being connected to the set of electrodes of the LED chip; and
an insulating layer formed on and covering a surface of the encapsulation layer, the insulating layer covering the wiring layer, the insulating layer comprising a structure of one or more layers, at least one of which is a transparent layer.

2. The light-emitting diode package assembly of claim 1, **characterized in that** a transmittance of the transparent layer is 50% or more.

3. The light-emitting diode package assembly of claim 1, **characterized in that** a transmittance of the transparent layer is greater than that of the encapsulation layer.

4. The light-emitting diode package assembly of claim 1, **characterized in that** the transparent layer does not contain micron-sized particles.

5. The light-emitting diode package assembly of claim 1, **characterized in that** the transparent layer is solidified from a photosensitive material.

6. The light-emitting diode package assembly of claim 1, **characterized in that** at least one layer of the insulating layer has a hardness greater than that of the wiring layer.

7. The light-emitting diode package assembly of claim 1, **characterized in that** the insulating layer has a hardness of D60 or more.

8. The light-emitting diode package assembly of claim 1, **characterized in that** the wiring layer comprises multiple layers of conductive wires, and the insulating layer insulates the multiple layers of conductive wires from each other.

9. The light-emitting diode package assembly of claim 8, **characterized in that** at least one layer of the multiple layers of conductive wires has a thickness of 50 µm or less.

10. The light-emitting diode package assembly of claim 1, **characterized in that** the encapsulation layer has a transmittance of 30% or less.

11. The light-emitting diode package assembly of claim 1, **characterized in that** further comprising a light-transmissive layer formed on the encapsulation layer and covering the first surfaces of the LED chips, the light-transmissive layer having a thickness of 20 µm or less.

12. The light-emitting diode package assembly of claim 11, **characterized in that** the light- transmissive layer has a transmittance of 40%~80%.

13. The light-emitting diode package assembly of claim 11, **characterized in that** the light-transmissive layer has a transmittance of 70% or more.

14. The light-emitting diode package assembly of claim 1, **characterized in that** the plurality of LED chips form a plurality of light-emitting units arranged in an m × n matrix, where n and m are integers greater than 1, each light-emitting unit comprising a first LED chip, a second LED chip and a third LED chip, the distance between each light-emitting unit is 1mm or less.

15. The light-emitting diode package assembly of claim 1, **characterized in that** a total thickness of the package assembly is between 100 ~ 500µm.

16. A light-emitting diode package assembly, comprising:
a plurality of LED chips spaced apart from one another, each LED chip comprising a first surface, a second surface opposite to the first surface, a side surface interconnecting the first surface and the second surface, and a set of electrodes formed on the second surface, the set of electrode comprising a first electrode and a second electrode, the first surface being a light-emitting surface;
a first encapsulation layer, filling gaps between the LED chips and covering the side surfaces of the LED chips, exposing the first electrodes, the second electrodes and at least part of the first surfaces of the LED chips, the first encapsulation layer being a colored layer;
a second encapsulation layer, formed on the first encapsulation layer and covering the first surfaces of the LED chips, second encapsulation layer being a light-transmissive layer with a predetermined transmittance greater than that of the first encapsulation layer;
a wiring layer formed on the second surfaces of the LED chips and having a first surface, a second surface opposite to the first surface, and a side surface interconnecting the first surface and the second surface, the first surface being connected to the set of electrodes of the LED chip; and
an insulating layer formed on and covering a surface of the encapsulation layer, the insulating layer covering the wiring layer.

17. The light-emitting diode package assembly of claim 16, **characterized in that** the first encapsulation layer has a transmittance of 50% or less.

18. The light-emitting diode package assembly of claim 16, **characterized in that** the first encapsulation layer has a transmittance of 0~30%.

19. The light-emitting diode package assembly of claim 16, **characterized in that** the first encapsulation layer includes light-absorbing particles.

20. The light-emitting diode package assembly of claim 16, **characterized in that** the second encapsulation layer has a transmittance of 40%~80%.

21. The light-emitting diode package assembly of claim 16, **characterized in that** the second encapsulation layer has a transmittance of 70% or more.

22. The light-emitting diode package assembly of claim 16, **characterized in that** the second encapsulation layer has a thickness of 5~20 µm.

23. The light-emitting diode package assembly of claim 16, **characterized in that** the second encapsulation layer is a scattering layer.

24. The light-emitting diode package assembly of claim 16, **characterized in that** the insulating layer comprising a structure of one or more layers, at least one of which has a hardness greater than that of the wiring layer.

25. The light-emitting diode package assembly of claim 16, **characterized in that** a height difference between the light-emitting surfaces of the LED chips is 10 µm or less.

26. The light-emitting diode package assembly of claim 16, **characterized in that** the insulating layer is made of the same material as the first encapsulation layer.

27. The light-emitting diode package assembly of claim 16, **characterized in that** the insulating layer comprises a structure of one or more layers, at least one of which is solidified from a photosensitive material.

28. The light-emitting diode package assembly of claim 16, **characterized in that** the wiring layer comprises multiple layers of conductive wires, and the insulating layer insulates the multiple layers of conductive wires from each other.

29. The light-emitting diode package assembly of claim 16, **characterized in that** the plurality of LED chips form a plurality of light-emitting units arranged in an m × n matrix, where n and m are integers greater than 1, each light-emitting unit comprising a first LED chip, a second LED chip and a third LED chip, the distance between each light-emitting unit is 1mm or less.

30. The light-emitting diode package assembly of claim 29, **characterized in that** the wiring layer includes multiple layers of conductive wires, and the number of layers is four or less.

31. The light-emitting diode package assembly of claim 16 or, **characterized in that** a total thickness of the package assembly is between 100 ~ 500 µm.
